(19) Europäisches Patentamt
European Patent Office
Office européen des brevets

(11) **EP 4 026 630 A1**

(12) **EUROPEAN PATENT APPLICATION**
published in accordance with Art. 153(4) EPC

(43) Date of publication:
**13.07.2022 Bulletin 2022/28**

(21) Application number: **20861431.3**

(22) Date of filing: **12.08.2020**

(51) International Patent Classification (IPC):
**B22F 1/00** (2022.01)       **B22F 1/02** (2006.01)
**B22F 7/08** (2006.01)       **H01B 1/00** (2006.01)
**H01B 1/22** (2006.01)       **H01B 5/00** (2006.01)
**H01L 21/52** (2006.01)

(52) Cooperative Patent Classification (CPC):
**B22F 1/00; B22F 1/16; B22F 7/08; H01B 1/00; H01B 1/22; H01B 5/00; H01L 21/52**

(86) International application number:
**PCT/JP2020/030725**

(87) International publication number:
**WO 2021/044817 (11.03.2021 Gazette 2021/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **02.09.2019 JP 2019159858**

(71) Applicant: **Osaka Soda Co., Ltd.**
**Osaka-shi**
**Osaka 550-0011 (JP)**

(72) Inventors:
• **OKUDA, Masatoshi**
  **Osaka-shi, Osaka 550-0011 (JP)**
• **MORI, Takamichi**
  **Osaka-shi, Osaka 550-0011 (JP)**
• **MINAMI, Junichiro**
  **Osaka-shi, Osaka 550-0011 (JP)**
• **IWASA, Naruhito**
  **Osaka-shi, Osaka 550-0011 (JP)**

(74) Representative: **Müller-Boré & Partner**
**Patentanwälte PartG mbB**
**Friedenheimer Brücke 21**
**80639 München (DE)**

(54) **SILVER PARTICLES**

(57)   The present invention provides novel silver particles that when used as a conductive adhesive, are satisfactorily sintered at a low temperature without application of pressure during sintering of the conductive adhesive, and form a sintered body with high denseness and high mechanical strength (shear strength). Silver particles comprising silver particles A with an average particle diameter in the range of 50 to 500 nm, and silver particles B with an average particle diameter in the range of 0.5 to 5.5 $\mu$m, wherein the silver particles satisfy a relationship in which the average particle diameter of the silver particles B is 5 to 11 times the average particle diameter of the silver particles A.

EP 4 026 630 A1

## Description

Technical Field

The present invention relates to silver particles, a conductive adhesive, a sintered body of the conductive adhesive, and an electronic part comprising the sintered body between members.

Background Art

Conductive adhesives, such as die-bonding agents, are bonding materials used in electronic parts, such as semiconductors, LEDs, and power semiconductors. A commonly known bonding method involves bonding such a bonding material to a substrate, by bonding using pressure and heating, or by sintering using heating or the like without pressure. The development of bonding materials of the pressureless method has recently been ongoing, from the viewpoint of the efficiency and simplicity of the production process.

One example of bonding materials of the pressureless method is a conductive adhesive containing an epoxy resin. This bonding material is used by curing the epoxy resin by a low-temperature treatment, and can reduce the formation of voids, and improve the bonding strength to substrates (Patent Literature 1). However, because the epoxy resin itself is a resistor, the resulting conductivity and thermal conductivity are reduced.

The development of silver particles, as a bonding material not containing a thermosetting resin such as an epoxy resin, has recently been ongoing. Silver particles have the property of being easily sintered by a heat treatment at a low temperature in a short period of time. Patent Literature 2, for example, discloses a metal paste obtained by kneading solids composed of silver particles and a solvent, wherein the solids are composed of silver particles including 30% or more of silver particles with particle diameters of 100 to 200 nm based on the number of particles, and an amine compound containing 4 to 8 carbon atoms in total as a protective agent is bound to the silver particles constituting the solids. According to Patent Literature 2, this metal paste allows sintering of the silver particles at a temperature in a low-temperature range, and is also capable of forming a sintered body having low resistance or a sintered body having excellent thermal conductivity.

Citation List

Patent Literature

Patent Literature 1: WO 2010/18712
Patent Literature 2: JP 2015-159096 A

Summary of Invention

Technical Problem

In the field of conductive adhesives, in general, pressure (a pressure of about 10 to 30 MPa, for example) is applied to a conductive adhesive during sintering, in order to reduce cavities (increase the denseness) of a sintered body obtained by applying the conductive adhesive to a member (such as a substrate, a semiconductor chip, or the like used in an electronic part) and sintering. Sintering the conductive adhesive while applying pressure can reduce cavities of the sintered body. If there are many cavities in the sintered body, the sintered body has problems in terms of reliability, such as poor mechanical strength (shear strength) and susceptibility to cracking and chipping in the sintered body. On the other hand, there are problems with the application of pressure during sintering, such as damage to the member coated with the conductive adhesive, and the need to provide special equipment for pressure application. Another problem is that when a sintered body is to be formed on a semiconductor chip or the like with a complicated structure, pressure cannot be applied to the conductive adhesive.

Thus, there has recently been a need for the development of a conductive adhesive that forms a sintered body with high denseness and high mechanical strength (shear strength), without application of pressure during sintering of the conductive adhesive.

Additionally, while conductive adhesives are generally sintered at a sintering temperature of about 300°C, there has been a need for a conductive adhesive that can be sintered at a lower temperature (for example, a sintering temperature of 250°C or less).

The above-described problems can be solved if a novel conductive adhesive is provided that is satisfactorily sintered at a low temperature without application of pressure during sintering of the conductive adhesive, and forms a sintered body with high denseness and high mechanical strength (shear strength).

Under such circumstances, it is a main object of the present invention to provide novel silver particles that when used as a conductive adhesive, are satisfactorily sintered at a low temperature without application of pressure during sintering of the conductive adhesive, and form a sintered body with high denseness and high mechanical strength (shear strength). It is also an object of the present invention to provide a conductive adhesive comprising the silver particles, a sintered body of the conductive adhesive, and an electronic part comprising the sintered body between members.

Solution to Problem

The present inventors have conducted extensive research to achieve the aforementioned objects. As a result, they have found that regarding silver particles in which relatively small silver particles with an average particle diameter in a predetermined range and relatively large silver particles with an average particle diameter in a predetermined range are used, and the average particle diameters of the large silver particles and the small silver particles are adjusted to have a specific relationship, when the silver particles are used as a conductive adhesive, they are satisfactorily sintered at a low temperature without application of pressure during sintering of the conductive adhesive, and form a sintered body with high denseness and high mechanical strength (shear strength). The present invention has been completed as a result of further research based on this finding.

In summary, the present invention provides aspects of the invention as set forth below:

Item 1. Silver particles comprising:

silver particles A with an average particle diameter in the range of 50 to 500 nm; and
silver particles B with an average particle diameter in the range of 0.5 to 5.5 $\mu$m,
wherein the silver particles satisfy a relationship in which the average particle diameter of the silver particles B is 5 to 11 times the average particle diameter of the silver particles A.

Item 2. The silver particles according to item 1, wherein the mass ratio of the silver particles A to the silver particles B is in the range of 1:9 to 9:1.

Item 3. The silver particles according to item 1 or 2, wherein an amine compound is adhered to a surface of the silver particles A.

Item 4. The silver particles according to any one of items 1 to 3, wherein the silver particles comprise silver particles with a particle diameter of less than 50 nm.

Item 5. A conductive adhesive comprising the silver particles according to any one of items 1 to 4 and a solvent.

Item 6. A sintered body of the conductive adhesive according to item 5.

Item 7. An electronic part in which members are bonded with the sintered body according to item 6.

Item 8. A method for producing a sintered body, comprising the step of sintering the conductive adhesive according to item 5 at a temperature of 200°C or more and 250°C or less.

Item 9. A method for producing an electronic part in which members are bonded with a sintered body, comprising the steps of:

placing the conductive adhesive according to item 5 between the members; and
sintering the conductive adhesive at a temperature of 200°C or more and 250°C or less.

Advantageous Effects of Invention

The present invention can provide novel silver particles that when used as a conductive adhesive, are satisfactorily sintered at a low temperature without application of pressure during sintering of the conductive adhesive, and form a sintered body with high denseness and high mechanical strength (shear strength). The present invention can also provide a conductive adhesive comprising the silver particles, a sintered body of the conductive adhesive, and an electronic part comprising the sintered body between members.

Brief Description of Drawings

FIG. 1 is a SEM image of silver particles A1.
FIG. 2 is a SEM image of silver particles A2.

FIG. 3 is a SEM image of silver particles B1.
FIG. 4 is a SEM image of silver particles B2.
FIG. 5 is a SEM image of silver particles B3.
FIG. 6 shows TG-DTA charts acquired for the silver particles A1 and A2.

Description of Embodiments

Silver particles of the present invention comprise silver particles A with an average particle diameter in the range of 50 to 500 nm, and silver particles B with an average particle diameter in the range of 0.5 to 5.5 $\mu$m, wherein the silver particles satisfy a relationship in which the average particle diameter of the silver particles B is 5 to 11 times the average particle diameter of the silver particles A. Because of these features, the silver particles of the present invention are provided as novel silver particles that when used as a conductive adhesive, are satisfactorily sintered at a low temperature without application of pressure during sintering of the conductive adhesive, and form a sintered body with high denseness and high mechanical strength (shear strength).

The silver particles of the present invention, a conductive adhesive, a sintered body of the conductive adhesive, and an electronic part comprising the sintered body between members will be hereinafter described in detail. As used herein, values connected with "to" refer to the numerical range including the values before and after "to" as the lower and upper limits. When a plurality of lower limits and a plurality of upper limits are mentioned separately, any lower limit and any upper limit may be selected and connected with "to".

1. Silver Particles

The silver particles of the present invention are particles containing silver, which comprise silver particles A and silver particles B with different average particle diameters. The silver particles A have an average particle diameter in the range of 50 to 500 nm. The silver particles B have an average particle diameter in the range of 0.5 to 5.5 $\mu$m. The silver particles also satisfy a relationship in which the average particle diameter of the silver particles B is 5 to 11 times the average particle diameter of the silver particles A. Specifically, when, for example, the average particle diameter of the silver particles A is the lower limit of 50 nm, the average particle diameter of the silver particles B is in the range of 0.5 to 0.55 $\mu$m. On the other hand, when, for example, the average particle diameter of the silver particles A is the upper limit of 500 nm, the average particle diameter of the silver particles B is in the range of 2.5 to 5.5 $\mu$m.

The average particle diameter of the silver particles A is not limited as long as it is in the range of 50 to 500 nm; however, from the viewpoint of more satisfactorily achieving the effect of the present invention, the lower limit is preferably 60 nm or more, while the upper limit is preferably 300 nm or less, more preferably 250 nm or less, and still more preferably 200 nm or less. Preferred ranges include from 50 to 300 nm, from 50 to 250 nm, from 50 to 200 nm, from 60 to 300 nm, from 60 to 250 nm, and from 60 to 200 nm.

The average particle diameter of the silver particles B is not limited as long as it is in the range of 0.5 to 5.5 $\mu$m; however, from the viewpoint of more satisfactorily achieving the effect of the present invention, the lower limit is preferably 0.6 $\mu$m or more, while the upper limit is preferably 3.0 $\mu$m or less, more preferably 2.5 $\mu$m or less, and still more preferably 2.0 $\mu$m or less. Preferred ranges include from 0.5 to 3.0 $\mu$m, from 0.5 to 2.5 $\mu$m, from 0.5 to 2.0 $\mu$m, from 0.6 to 3.0 $\mu$m, from 0.6 to 2.5 $\mu$m, and from 0.6 to 2.0 $\mu$m.

As used herein, the average particle diameter of the silver particles refers to the volume-based average particle diameter measured for 200 randomly selected particles in a SEM image, using image analysis software (for example, Mac-View (Mountech Co., Ltd.)). The SED mode (secondary electron detector) is used in the observation, and a range with a horizontal width of 1 to 20 $\mu$m is observed at an acceleration voltage of 20 kV and an observation magnification of 5,000 to 30,000 times. With respect to the vertical direction of the SEM image, the width is set such that 200 or more (typically about 200 to 300) silver particles are included in the range with a horizontal width of 1 to 20 $\mu$m. The volume-based average particle diameter refers to the value measured based on the assumption that the particles observed in the SEM image have a spherical shape with the diameter. The specific measurement method is as described in the Examples.

The silver particles of the present invention satisfy the relationship in which the average particle diameter of the silver particles B is 5 to 11 times the average particle diameter of the silver particles A. From the viewpoint of more satisfactorily achieving the effect of the present invention, the silver particles of the present invention preferably satisfy a relationship in which the average particle diameter of the silver particles B is 8 to 11 times the average particle diameter of the silver particles A, and more preferably satisfy a relationship in which the average particle diameter of the silver particles B is 9 to 11 times the average particle diameter of the silver particles A.

In the silver particles of the present invention, the mass ratio of the silver particles A to the silver particles B (silver particles A:silver particles B) is preferably in the range of 1:9 to 9:1, more preferably in the range of 7:3 to 3:7, and still more preferably in the range of 6:4 to 4:6. The silver particles of the present invention predominantly contains the silver particles A and the silver particles B, and the total content of the silver particles A and silver particles B is preferably 80% by mass or more, more preferably 90% by mass or more, still more preferably 95% by mass or more, and particularly preferably 98% by mass or more, or may even be 100% by mass.

The silver particles of the present invention may contain silver particles with a particle diameter of less than 50 nm. However, from the viewpoint of more satisfactorily achieving the effect of the present invention, the proportion of the silver particles with a particle diameter of less than 50 nm is 30% or less, preferably 20% or less, and more preferably 10% or less, for example, based on the number of silver particles. The silver particles of the present invention may also contain silver particles with a particle diameter above 5.5 $\mu$m. However, from the viewpoint of more satisfactorily achieving the effect of the present invention, the proportion of the silver particles with a particle diameter above 5.5 $\mu$m is 30% or less, preferably 20% or less, and more preferably 10% or less, for example, based on the number of silver particles. As used herein, the particle diameter refers to the volume-based particle diameter, and is calculated using the above-described particle diameter measurement method. The number proportions of these particles are measured from the 200 silver particles, using image analysis software (Mac-View).

In the silver particles of the present invention, it is preferred that a plurality of exothermic peaks be observed in the range of 120 to 250°C in thermogravimetry-differential thermal analysis. Specifically, it is preferred that at least one (typically one) exothermic peak between 120 and 150°C and at least one (typically one or two) exothermic peak between 160 and 250°C be observed in thermogravimetry-differential thermal analysis. Moreover, a dry powder of the silver particles of the present invention preferably shows a weight loss of 1.5% by weight or less, and more preferably shows a weight loss of 0.05 to 1.3% by weight, upon heating from 30 to 500°C by thermogravimetry-differential thermal analysis. The method of thermogravimetry-differential thermal analysis is as follows.

<Thermogravimetry-Differential Thermal Analysis (TG-DTA)>

Initially, air-dried silver particles are prepared. For example, when silver particles acquired from a conductive adhesive are to be analyzed, 1 g of the conductive adhesive is dispersed well in 2 g of added methanol, and then the silver particles are collected by filtration and air-dried to obtain a silver-particle dry powder to be analyzed. The silver-particle dry powder is subjected to TG-DTA measurement, using a thermogravimetry-differential thermal analyzer (for example, HITACHI G300 AST-2). The measurement conditions are as follows: atmosphere: air, measurement temperature: 30 to 500°C, heating rate: 10°C/min. From the obtained TG-DTA chart, the exothermic peaks due to binding of the silver particles in the TG-DTA analysis and the weight loss on heating from 30 to 500°C by the thermal analysis are obtained.

The silver content in the silver particles of the present invention is preferably 95% by mass or more, and more preferably 98% by mass or more.

From the viewpoint of more satisfactorily achieving the effect of the present invention, the silver particles are preferably subjected to a surface treatment. That is, the silver particles of the present invention are preferably surface-treated silver particles.

More specifically, in the silver particles of the present invention, it is preferred that an amine compound be adhered to a surface of the silver particles A. An amine compound may also be adhered to a surface of the silver particles B. The amine compound can be adhered to the surface of the silver particles to form a protective layer. In the silver particles of the present invention, it is preferred to adhere the amine compound such that the average particle diameters are set in the above-described specific ranges.

While the amine compound is not limited, it is preferably an alkylamine, from the viewpoint of more satisfactorily achieving the effect of the present invention. While the alkylamine is not limited, it is preferably an alkylamine in which the alkyl group contains 3 or more and 18 or less carbon atoms, and is more preferably an alkylamine in which the alkyl group contains 4 or more and 12 or less carbon atoms.

Specific preferred examples of the alkylamine include ethylamine, n-propylamine, isopropylamine, 1,2-dimethylpropylamine, n-butylamine, isobutylamine, sec-butylamine, tert-butylamine, isoamylamine, tert-amylamine, 3-pentylamine, n-amylamine, n-hexylamine, n-heptylamine, n-octylamine, 2-octylamine, 2-ethylhexylamine, n-nonylamine, n-aminodecane, n-aminoundecane, n-dodecylamine, n-tridecylamine, 2-tridecylamine, n-tetradecylamine, n-pentadecylamine, n-hexadecylamine, n-heptadecylamine, n-octadecylamine, n-oleylamine, N-ethyl-1,3-diaminopropane, N,N-diisopropylethylamine, N,N-dimethylaminopropane, N,N-dibutylaminopropane, N,N-dimethyl-1,3-diaminopropane, N,N-diethyl-1,3-diaminopropane, N,N-diisobutyl-1,3-diaminopropane, and N-lauryl diaminopropane. Examples also include dibutyl amine, which is a secondary amine, and cyclopropylamine, cyclobutylamine, cyclopropylamine, cyclohexylamine, cycloheptylamine, and cyclooctylamine, which are cyclic alkylamines. From the viewpoint of more satisfactorily achieving the effect of the present invention, preferred among the above are n-propylamine, isopropylamine, cyclopropylamine, n-butylamine, isobutylamine, sec-butylamine, tert-butylamine, cyclobutylamine, n-amylamine, n-hexylamine, cyclohexylamine, n-octylamine, 2-ethylhexylamine, n-dodecylamine, n-oleylamine, N,N-dimethyl-1,3-diaminopropane, and N,N-diethyl-1,3-diaminopropane; and more preferred are n-butylamine, n-hexylamine, cyclohexylamine, n-octylamine, n-dodecylamine, N,N-dimethyl-1,3-diaminopropane, and N,N-diethyl-1,3-diaminopropane. These amine compounds may be used alone or in combination.

While the amount of the amine compound to be adhered to the silver particles of the present invention is not limited, it is preferably 1.5% by mass or less, and more preferably 1.3% by mass or less, based on the mass of the silver particles taken as 100% by mass, while the lower limit is preferably 0.05% by mass or more. Likewise, the amount of the amine compound to be adhered to the silver particles A or B is preferably 1.5% by mass or less, and more preferably 1.3% by mass or less, based on the mass of silver particles A or B taken as 100%, while the lower limit is preferably 0.05% by mass or more. The content of the amine compound adhered to the silver particles can be measured by thermogravimetry-differential thermal analysis.

A fatty acid, a hydroxyfatty acid, or the like may also be adhered to the surface of the silver particles. While the fatty acid is not limited, it is preferably a fatty acid in which the alkyl group contains 3 or more and 18 or less carbon atoms, and is more preferably a fatty acid in which the alkyl group contains 4 or more and 18 or less carbon atoms. Specific preferred examples of the fatty acid include acetic acid, propionic acid, butyric acid, valeric acid, caproic acid, caprylic acid, 2-ethylhexanoic acid, capric acid, lauric acid, myristic acid, palmitic acid, stearic acid, oleic acid, linoleic acid, and α-linolenic acid. Specific examples of the fatty acid also include cyclic alkylcarboxylic acids, such as cyclohexanecarboxylic acid. The hydroxyfatty acid may be a compound containing 3 to 24 carbon atoms, and having one or more (for example, one) hydroxyl groups. Examples of the hydroxyfatty acid include 2-hydroxydecanoic acid, 2-hydroxydodecanoic acid, 2-hydroxytetradecanoic acid, 2-hydroxyhexadecanoic acid, 2-hydroxyoctadecanoic acid, 2-hydroxyeicosanoic acid, 2-hydroxydocosanoic acid, 2-hydroxytricosanoic acid, 2-hydroxytetracosanoic acid, 3-hydroxyhexanoic acid, 3-hydroxyoctanoic acid, 3-hydroxynonanoic acid, 3-hydroxydecanoic acid, 3-hydroxyundecanoic acid, 3-hydroxydodecanoic acid, 3-hydroxytridecanoic acid, 3-hydroxytetradecanoic acid, 3-hydroxyhexadecanoic acid, 3-hydroxyheptadecanoic acid, 3-hydroxyoctadecanoic acid, ω-hydroxy-2-decenoic acid, ω-hydroxypentadecanoic acid, ω-hydroxyheptadecanoic acid, ω-hydroxyeicosanoic acid, ω-hydroxydocosanoic acid, 6-hydroxyoctadecanoic acid, ricinoleic acid, 12-hydroxystearic acid, and [R-(E)]-12-hydroxy-9-octadecenoic acid. Preferred among the above are hydroxyfatty acids containing 4 to 18 carbon atoms, and having one hydroxyl group at a position other than the ω-position (particularly the 12-position), and more preferred are ricinoleic acid and 12-hydroxystearic acid. These fatty acids may be used alone or in combination. Likewise, these hydroxyfatty acids may be used alone or in combination.

In the silver particles of the present invention, the amount of the fatty acid or the hydroxyfatty acid to be adhered is also adjusted appropriately, as with the amine compound. While the amount of the fatty acid or the hydroxyfatty acid to be adhered is not specifically limited, it is preferably 1.5% by mass or less, and more preferably 1.3% by mass or less, based on the mass of the silver particles taken as 100% by mass, while the lower limit is preferably 0.01% by mass or more. Likewise, the amount of the fatty acid or the hydroxyfatty acid to be adhered to the silver particles A or B is preferably 1.5% by mass or less, and more preferably 1.3% by mass or less, based on the mass of silver particles A or B taken as 100%, while the lower limit is preferably 0.01% by mass or more. The content of the fatty acid or the hydroxyfatty acid adhered to the silver particles can be measured by thermogravimetry-differential thermal analysis.

As long as the silver particles of the present invention satisfy the above-described average particle diameters, the amine compound, the fatty acid, and the hydroxyfatty acid may be used in combination, or another compound different from these compounds may be adhered to the surface of the silver particles. It is particularly preferred that the amine compound be adhered to the surface of the silver particles of the present invention.

The silver particles of the present invention, when used as a conductive adhesive, are heated at 200°C to give a sintered body with a shear strength of preferably 73 MPa or more, more preferably 77 MPa or more, still more preferably 80 MPa or more. The upper limit of the shear strength is 200 MPa or less, for example. Moreover, the silver particles of the present invention, when used as a conductive adhesive, are heated at 250°C to give a sintered body with a shear strength of preferably 70 MPa or more, more preferably 72 MPa or more, still more preferably 75 MPa or more. The upper limit of the shear strength is 200 MPa or less, for example. The method of measuring the shear strength of the sintered body is as described below. Specifically, the shear strength is measured using the method described in the Examples.

<Shear Strength>

Initially, a substrate formed of a copper sheet coated with 0.5 μm of electroless silver plating is prepared. A conductive adhesive (silver particle dispersion containing 90% by mass of the silver particles and 10% by mass of Texanol) is uniformly applied onto the substrate (silver-plated surface) to give a coating thickness of 50 μm. On the coating, a silicon wafer (size: 2 mm × 2 mm) gold-plated on the rear surface (surface brought into contact with the conductive adhesive) is laminated to obtain a laminate. Then, the obtained laminate is heated using a (circulation-type) dryer at a predetermined sintering temperature (200 or 250°C) for 60 minutes. In this manner, nine such laminates are prepared in which each conductive adhesive between the substrate and the silicon wafer has been sintered, and the substrate and the silicon wafer have been bonded with the sintered body therebetween. For each of the obtained laminates, to measure the maximum load at break, a die shear test is performed for each laminate, by applying a load on the sintered body under a condition of 0.120 mm/s, using a bond tester (for example, SS30-WD; Seishin Trading Co., Ltd.) at room temperature. The shear strength value is obtained by dividing the maximum load thus obtained by the bonded area. The measured result is the average value of the nine gold-plated silicon wafers measured for shear strength.

The silver particles of the present invention, when used as a conductive adhesive, are heated at 200°C to give a sintered body with a denseness of preferably 80% or more, more preferably 83% or more. The upper limit of the denseness is 95% or less, for example. Moreover, the silver particles of the present invention, when used as a conductive adhesive, are heated at 250°C to give a sintered body with a denseness of preferably 83% or more, more preferably 85% or more. The upper limit of the denseness is 97% or less, for example. The method of measuring the denseness of the sintered body is as described below. Specifically, the denseness is measured using the method described in the Examples.

<Denseness>

In the same manner as described in the <Shear Strength> section, laminates in which the substrate and the silicon wafer have been bonded with the sintered body therebetween are obtained. Next, the sintered body in the laminate is resin-embedded in an epoxy resin (from Buehler, for example), and allowed to stand for 24 hours to cure the resin. Next, the resin-embedded laminate is cut with a precision low-speed cutter (for example, TechCut4 from ALLIED), and subjected to cross-section milling, using (for example, Hitachi High-Technologies Corporation) ion milling (for example, IM4000PLUS from Hitachi High-Technologies Corporation). The cross-section milling is performed by irradiating with an ion beam at a discharge voltage of 1.5 kV and an acceleration voltage of 6 kV, using an argon gas flow rate of 0.07 cm$^3$/min and a swing of $\pm30°$. The cross section of the sintered body obtained by the cross-section milling is observed with a scanning electron microscope to acquire an SEM image. The SED mode (secondary electron detector) is used in the observation, and a range with a horizontal width of 60 $\mu$m is observed at an acceleration voltage of 20 kV and a magnification of 2,000 times. With respect to the vertical direction of the SEM image, the vertical width of the sintered layer of silver is set in the range of 10 $\mu$m or more and 200 $\mu$m or less. This is because, if the sintered layer of silver is less than 10 $\mu$m in width, the mechanical strength may be impaired, owing to the properties of the bonded body; whereas if the sintered layer of silver is above 200 $\mu$m in width, the bulk of the laminate is so high that uniform outgassing during sintering would be less likely to occur, which is disadvantageous from the viewpoint of reliability. To calculate the density, the obtained SEM image is converted into a two-shade image of black and white using binarization software (Imagej), and the density is determined using the following relational expression:

$$\text{Denseness (\%)} = \text{sintered silver area (number of white pixels)} \div \text{total area of}$$
$$\text{the sintered body \{sintered silver area (number of white pixels)} + \text{area of pores (number}$$
$$\text{of black pixels)\}} \times 100$$

<Specific Resistance>

A conductive adhesive (silver particle dispersion containing 90% by mass of the silver particles and 10% by mass of Texanol) is uniformly applied onto a polyimide film to give a size of 2 mm $\times$ 60 mm $\times$ 50 $\mu$m in coating thickness, and fired at a predetermined temperature (200 or 250°C) for 60 minutes to obtain a sintered body. Next, the resistance of the sintered body is measured with a resistance meter (for example, HIOKI RM3548) under room temperature conditions, and the specific resistance (volume resistance) is determined from the actual film thickness measured with a micrometer. The specific resistance refers to the average of the values measured at four places of the sintered body.

The silver particles of the present invention, when used as a conductive adhesive, are heated at 200°C to give a sintered body with a specific resistance of preferably 3.5 $\mu\Omega\cdot$cm or less, more preferably 3.2 $\mu\Omega\cdot$cm or less, still more preferably 3.0 $\mu\Omega\cdot$cm or less. The lower limit of the specific resistance is 2.0 $\mu\Omega\cdot$cm or more, for example. Moreover, the silver particles of the present invention, when used as a conductive adhesive, are heated at 250°C to give a sintered body with a specific resistance of preferably 3.2 $\mu\Omega\cdot$cm or less, more preferably 3.0 $\mu\Omega\cdot$cm or less. The lower limit of the specific resistance is 1.8 $\mu\Omega\cdot$cm or more, for example. The method of measuring the specific resistance of the sintered body is as described in the <Specific Resistance> section above. Specifically, the specific resistance is measured using the method described in the Examples.

<Cavities>

A SEM image binarized using Imagej, acquired from a SEM image of the sintered body in the same manner as described in the measurement of <Denseness> above, is subjected to image processing (by automatic color difference reading, the cavity regions in the binarized image are analyzed as particles) using image analysis-type particle size distribution measurement software (Mac-View (Mountech Co., Ltd.)). Based on the assumption that the cavities of the sintered body have a spherical shape, the number average size of the cavities is calculated. Here, the specific surface area of the sintered body is calculated from the surface area per unit volume of the spherical shape. The cavity regions refer to pore regions produced by outgassing or particle growth, and are different from voids and cracks; the pore regions have a diameter of 50 nm or more and 10 $\mu$m or less. Holes with a size of 10 $\mu$m or more are referred to as voids or cracks, and are excluded from the cavity regions in the calculation.

The silver particles of the present invention, when used as a conductive adhesive, are heated at 200°C to give a sintered body with cavities having the following characteristics, for example. The sintered body is formed in the manner described in the <Shear Strength> section above. The number average size of the cavities is 0.3 to 1.0 $\mu$m, for example. The specific surface area of the cavities is 0.2 to 1.0 $\mu$m$^2$, for example. The number average size is calculated using the above-described image processing method with Mac-View.

2. Method for Producing the Silver Particles

One example of a method for producing the silver particles of the present invention will be hereinafter described.

Initially, a composition for producing the silver particles (silver particle-preparation composition) is prepared. Specifically, a silver compound as a raw material of the silver particles, and optionally, the amine compound and the like to be adhered to the surface of the silver particles and a solvent, are prepared. From the viewpoint of more satisfactorily achieving the effect of the present invention, the silver compound is preferably silver nitrate, silver oxalate, or the like, and is particularly preferably silver oxalate. Examples of the solvent include the same solvents as those mentioned as the solvent to be contained in the conductive adhesive described below. Next, these components are mixed to obtain a silver particle-preparation composition. The proportions of these components in the composition are appropriately adjusted. For example, the silver oxalate content in the composition is preferably about 20 to 70% by mass, based on the total amount of the composition. When the amine compound is to be adhered to the surface of the silver particles, the amine compound content is preferably about 5 to 55% by mass, based on the total amount of the composition. When the fatty acid is to be adhered to the surface of the silver particles, the fatty acid content is preferably about 0.1 to 20% by mass, based on the total amount of the composition. When the hydroxyfatty acid is to be adhered to the surface of the silver particles, the hydroxyfatty acid content is preferably about 0.1 to 15% by mass, based on the total amount of the composition.

Alternatively, the following method can be adopted. Silver particles are synthesized first, using a silver particle-preparation composition adjusted such that the contents of the amine compound and the like fall outside the above-described ranges, and then the types and amounts of the amine compound and the like to be adhered are adjusted (the amine compound is replaced) to achieve the above-described physical properties, using the below-described method.

The means of mixing the components is not limited, and the mixing may be performed using a general-purpose device, such as a mechanical stirrer, a magnetic stirrer, a vortex mixer, a planetary mill, a ball mill, a three-roll, a line mixer, a planetary mixer, or a dissolver. In order to avoid an increase in the temperature of the composition due to the influence of the heat of dissolution, frictional heat, and the like during mixing, which may initiate the pyrolysis reaction of the silver particles, it is preferred to perform the mixing while keeping the temperature of the composition at, for example, 60°C or less, particularly 40°C or less.

Next, the silver particle-preparation composition is reacted, typically by heating, in a reaction vessel, to cause the pyrolysis reaction of the silver compound, resulting in the formation of silver particles. The reaction may be performed by introducing the composition into a previously heated reaction vessel, or introducing the composition into a reaction vessel and then heating.

The reaction temperature may be any temperature that allows the pyrolysis reaction to proceed, and allows the silver particles to form, for example, about 50 to 250°C. The reaction time may be selected appropriately according to the desired size of the average particle diameter and the corresponding composition of the composition. The reaction time is, for example, from 1 minute to 100 hours.

The silver particles formed by the pyrolysis reaction are obtained as a mixture containing unreacted raw material, and thus, are preferably purified. Examples of purification methods include solid-liquid separation methods and a sedimentation method utilizing the difference in specific gravity between the silver particles and the unreacted raw material such as an organic solvent. Examples of solid-liquid separation methods include filtration, centrifugation, a cyclone method, and decantation. For ease of handling during purification, the viscosity of the mixture containing the silver particles may be adjusted by diluting it with a low-boiling-point solvent, such as acetone or methanol.

The average particle diameter of the silver particles to be obtained can be adjusted by adjusting the composition and reaction conditions of the silver particle-production composition.

Method of Replacing and Adjusting the Amine Compound on the Surface of the Silver Particles

Silver particles (in which the amine compound is adhered to the surface) synthesized first using the method described above are prepared and then dispersed in a solvent. Examples of the solvent include the same solvents as those mentioned as the solvent to be contained in the conductive adhesive described below. Next, another amine compound is added in an amount in the range of 0.1 to 5 times the mass of the silver particles, and the mixture is subjected to the step of stirring for 1 minute to 24 hours at room temperature to 80°C. As a result, the type of the amine compound adhered to the surface of the silver particles can be replaced, and the amount of the amine compound adhered can be adjusted. The silver particles in which the amine compound has been replaced can be collected using the above-described solid-liquid separation methods, for example.

3. Conductive Adhesive

The conductive adhesive of the present invention comprises the silver particles of the present invention and a solvent. The inclusion of the solvent improves flowability, which facilitates placing the conductive adhesive of the present invention in a desired place. Details of the silver particles of the present invention are as described above.

While the solvent is not limited as long as it can disperse the silver particles, it preferably contains a polar organic solvent. Examples of the polar organic solvent include ketones, such as acetone, acetylacetone, and methyl ethyl ketone; ethers, such as diethyl ether, dipropyl ether, dibutyl ether, tetrahydrofuran, and 1,4-dioxane; diols, such as 1,2-propanediol, 1,2-butanediol, 1,3-butanediol, 1,4-butanediol, 2,3-butanediol, 1,2-hexanediol, 1,6-hexanediol, 1,2-pentanediol, 1,5-pentanediol, 2-methyl-2,4-pentanediol, 3-methyl-1,5-pentanediol, 1,2-octanediol, 1,8-octanediol, and 2-ethyl-1,3-hexanediol; glycerol; alcohols, such as linear or branched alcohols containing 1 to 5 carbon atoms, cyclohexanol, 3-methoxy-3-methyl-1-butanol, and 3-methoxy-l-butanol; fatty acid esters, such as ethyl acetate, butyl acetate, ethyl butylate, ethyl formate, and Texanol; glycols or glycol ethers, such as polyethylene glycol, triethylene glycol monomethyl ether, tetraethylene glycol monomethyl ether, ethylene glycol monoethyl ether, diethylene glycol monoethyl ether, diethylene glycol dimethyl ether, triethylene glycol dimethyl ether, tetraethylene glycol dimethyl ether, 3-methoxybutyl acetate, ethylene glycol monobutyl ether, ethylene glycol monobutyl ether acetate, ethylene glycol monohexyl ether, ethylene glycol monooctyl ether, ethylene glycol mono-2-ethylhexyl ether, ethylene glycol monobenzyl ether, diethylene glycol monomethyl ether, diethylene glycol monomethyl ether acetate, diethylene glycol monoethyl ether, diethylene glycol monoethyl ether acetate, diethylene glycol monobutyl ether, diethylene glycol monobutyl ether acetate, diethylene glycol monohexyl ether, diethylene glycol mono-2-ethylhexyl ether, polypropylene glycol, propylene glycol monopropyl ether, propylene glycol monobutyl ether, dipropylene glycol monomethyl ether, dipropylene glycol monoethyl ether, dipropylene glycol monopropyl ether, dipropylene glycol monobutyl ether, tripropylene glycol monomethyl ether, tripropylene glycol monoethyl ether, tripropylene glycol monopropyl ether, and tripropylene glycol monobutyl ether; N,N-dimethylformamide; dimethylsulfoxide; terpenes, such as terpineol; acetonitrile; γ-butyrolactone; 2-pyrrolidone; N-methylpyrrolidone; and N-(2-aminoethyl)piperazine. From the viewpoint of more satisfactorily achieving the effect of the present invention, preferred among the above are linear or branched alcohols containing 3 to 5 carbon atoms, 3-methoxy-3-methyl-1-butanol, 3-methoxy-l-butanol, diethylene glycol monobutyl ether, diethylene glycol monobutyl ether acetate, diethylene glycol monohexyl ether, diethylene glycol mono-2-ethylhexyl ether, terpineol, and Texanol.

The solvent may also contain a nonpolar or hydrophobic solvent, in addition to the polar organic solvent. Examples of the nonpolar organic solvent include linear, branched, or cyclic saturated hydrocarbons, such as hexane, heptane, octane, nonane, decane, 2-ethylhexane, and cyclohexane; alcohols, such as linear or branched alcohols containing 6 or more carbon atoms; aromatic compounds, such as benzene, toluene, and benzonitrile; halogenated hydrocarbons, such as dichloromethane, chloroform, and dichloroethane; methyl-n-amyl ketone; methyl ethyl ketone oxime; and triacetin. Preferred among the above are saturated hydrocarbons and linear or branched alcohols containing 6 or more carbon atoms, and more preferred are hexane, octane, decane, octanol, decanol, and dodecanol. These solvents may be used alone or as a mixture of two or more.

When the solvent contains both a polar organic solvent and a nonpolar organic solvent, the proportion of the polar organic solvent is preferably 5% by volume or more, more preferably 10% by volume or more, and still more preferably 15% by volume or more, based on the total volume of the solvent. The proportion of the polar organic solvent may also be 60% by volume or less, 55% by volume or less, or 50% by volume or less. The solvent may contain a polar organic solvent only. Even when the conductive adhesive of the present invention contains a large amount of polar organic solvent as in this case, it has good dispersibility of the silver particles.

While the proportion of the solvent is not limited in the conductive adhesive of the present invention, it is preferably 20% by mass or less, and more preferably about 5 to 15% by mass.

The silver particle content in the conductive adhesive of the present invention is preferably 80% by mass or more, and more preferably 85% by mass or more.

The conductive adhesive of the present invention can be produced using a method comprising the step of mixing the silver particles of the present invention and the solvent.

Furthermore, in the method for producing the conductive adhesive of the present invention, the silver particles of the present invention formed in the solvent, in the above-described method for producing the silver particles of the present invention, may be used together with the solvent as the conductive adhesive of the present invention.

### 4. Sintered Body of the Conductive Adhesive

A sintered body of the conductive adhesive of the present invention is obtained by sintering the conductive adhesive of the present invention described in detail in the "2. Conductive Adhesive" section above. In the sintered body of the conductive adhesive of the present invention, the components (amine compound and the like) adhered to the surface of the silver particles and the solvent have been mostly eliminated by the high heat applied during sintering, and the sintered body is substantially composed of silver.

While the sintering temperature is not limited, it is, for example, 250°C or less, preferably about 150 to 250°C, and more preferably about 200 to 250°C, from the viewpoint of sintering the conductive adhesive satisfactorily at a low temperature, and simultaneously improving the shear strength and denseness of the resulting sintered body. From the same viewpoint, the sintering time is preferably about 0.4 to 2.0 hours, and more preferably about 0.5 to 1.2 hours. In the present invention, the silver particles contained in the conductive adhesive comprise silver particles A with an average particle diameter in the range of 50 to 500 nm, and silver particles B with an average particle diameter in the range of 0.5 to 5.5 $\mu$m, wherein the silver particles satisfy a relationship in which the average particle diameter of the silver particles B is 5 to 11 times the average particle diameter of the silver particles A, so that the silver particles are satisfactorily sintered at a low temperature of 250°C or less without application of pressure during sintering of the conductive adhesive, and form a sintered body with high denseness and high mechanical strength (shear strength). Thus, it is not necessary to apply pressure during sintering of the conductive adhesive of the present invention. That is, the conductive adhesive of the present invention is suitable for use in applications in which it is used without pressure during sintering. Alternatively, pressure may be applied during sintering of the conductive adhesive of the present invention, in which case a pressure of about 10 to 30 MPa, for example, is applied. The sintering may be performed in an atmosphere such as air or an inert gas (nitrogen gas or argon gas). The sintering means is not limited, and examples include an oven, a hot air-type drying oven, an infrared drying oven, laser irradiation, flash lamp irradiation, and microwaves.

The sintered body of the present invention preferably satisfies at least one of the shear strength, the denseness, and the specific resistance as set forth in the "1. Silver Particles" section. The measurement methods therefor are as described in the <Shear Strength>, <Denseness>, and <Specific Resistance> sections above.

### 5. Electronic Part

An electronic part of the present invention comprises a region between members that is bonded with the sintered body of the present invention. That is, the electronic part of the present invention is obtained by placing the conductive adhesive of the present invention described in detail in the "2. Conductive Adhesive" section above between members of the electronic part (for example, between members included in a circuit), and sintering the conductive adhesive to bond the members.

As described above, the sintered body of the present invention has high denseness and high shear strength, and thus, the electronic part comprising the sintered body also has high shear strength between the members. The electronic part of the present invention can also have a low specific resistance.

### Examples

The present invention will be described in more detail with the following examples; however, the present invention is not limited thereto.

Details of the components used in the examples and comparative examples are as follows:

- Silver oxalate ($(COOAg)_2$) was synthesized using the method disclosed in Japanese Patent No. 5574761.
- N,N-diethyl-1,3-diaminopropane (from FUJIFILM Wako Pure Chemical Corporation)
- n-Hexylamine (containing 6 carbon atoms, from FUJIFILM Wako Pure Chemical Corporation)
- Ricinoleic acid (from Tokyo Chemical Industry Co., Ltd.)
- 1-Butanol (from FUJIFILM Wako Pure Chemical Corporation)
- Methanol (from FUJIFILM Wako Pure Chemical Corporation)

- Ethylene glycol (from FUJIFILM Wako Pure Chemical Corporation)
- Texanol (from FUJIFILM Wako Pure Chemical Corporation)

<Synthesis of Silver Particles A>

(1) Silver Particles A1 (Average Particle Diameter: 68 nm)

In 50-mL glass centrifuge tubes with a magnetic stirring bar, ricinoleic acid (2.34 g), N,N-diethyl-1,3-diaminopropane (203 g), and 1-butanol (375 g) were placed and stirred for about 1 minute, and then silver oxalate (250 g) was placed and stirred for about 10 minutes to obtain a silver particle A1-preparation composition. Thereafter, these glass centrifuge tubes were set upright on a hot stirrer equipped with an aluminum block (HHE-19G-U from Koike Precision Instruments), and stirred for 30 minutes at 40°C and additionally for 30 minutes at 90°C. After being left to cool, the magnetic stirring bar was removed, 15 g of methanol was added to the composition and stirred with a vortex mixer, the composition was then subjected to centrifugation at 3,000 rpm (about 1,600xG) for 1 minute using a centrifuge (CF7D2 from Hitachi Koki Co., Ltd.), and the supernatant was removed by tilting the centrifuge tubes. The process of adding 15 g of methanol, stirring, centrifugation, and removing the supernatant was repeated twice to collect silver particles.
Next, to the dispersion (methanol solution) of the silver particles thus obtained, n-hexylamine was added in an amount three times the mass of the silver particles, and stirred for 4 hours at room temperature. After stirring, the magnetic stirring bar was removed, 15 g of methanol was added to the composition and stirred with a vortex mixer, the composition was then subjected to centrifugation at 3,000 rpm (about 1,600xG) for 1 minute using a centrifuge (CF7D2 from Hitachi Koki Co., Ltd.), and the supernatant was removed by tilting the centrifuge tubes. The process of adding 15 g of methanol, stirring, centrifugation, and removing the supernatant was repeated twice to collect silver particles A1 (average particle diameter: 68 nm) in which N,N-diethyl-1,3-diaminopropane adhered to the surface of the silver particles was replaced with n-hexylamine.

(2) Silver Particles A2 (Average Particle Diameter: 181 nm)

In 50-mL glass centrifuge tubes with a magnetic stirring bar, ricinoleic acid (6.25 g), N,N-diethyl-1,3-diaminopropane (203 g), and 1-butanol (187.5 g) were placed and stirred for about 1 minute, and then silver oxalate (250 g) was placed and stirred for about 10 minutes to obtain a silver particle A1-preparation composition. Thereafter, these glass centrifuge tubes were set upright on a hot stirrer equipped with an aluminum block (HHE-19G-U from Koike Precision Instruments), and stirred for 30 minutes at 40°C and additionally for 30 minutes at 90°C. After being left to cool, the magnetic stirring bar was removed, 15 g of methanol was added to the composition and stirred with a vortex mixer, the composition was then subjected to centrifugation at 3,000 rpm (about 1,600xG) for 1 minute using a centrifuge (CF7D2 from Hitachi Koki Co., Ltd.), and the supernatant was removed by tilting the centrifuge tubes. The process of adding 15 g of methanol, stirring, centrifugation, and removing the supernatant was repeated twice to collect silver particles.
Next, to the dispersion (methanol solution) of the silver particles thus obtained, n-hexylamine was added in an amount three times the mass of the silver particles, and stirred for 4 hours at room temperature. After stirring, the magnetic stirring bar was removed, 15 g of methanol was added to the composition and stirred with a vortex mixer, the composition was then subjected to centrifugation at 3,000 rpm (about 1,600xG) for 1 minute using a centrifuge (CF7D2 from Hitachi Koki Co., Ltd.), and the supernatant was removed by tilting the centrifuge tubes. The process of adding 15 g of methanol, stirring, centrifugation, and removing the supernatant was repeated twice to collect silver particles A2 (average particle diameter: 181 nm) in which N,N-diethyl-1,3-diaminopropane was replaced with n-hexylamine.

<Silver Particles B>

- As silver particles B1 (average particle diameter: 0.65 $\mu$m), product name AG 2-1C from DOWA Electronics Materials Co., Ltd. was used.
- As silver particles B2 (average particle diameter: 1.88 $\mu$m), product name AG3-1F from DOWA Electronics Materials Co., Ltd. was used.
- As silver particles B3 (average particle diameter: 2.21 $\mu$m), product name AG4-8F from DOWA Electronics Materials Co., Ltd. was used.

For each type of the silver particles A1, A2, B1, B2, and B3, observation with a scanning electron microscope (acquisition of a SEM image), measurement of average particle diameter (volume-based average particle diameter), measurement of particle size distribution, and TG-DTA measurement were performed under the following conditions.

<Observation with Electron Microscope>

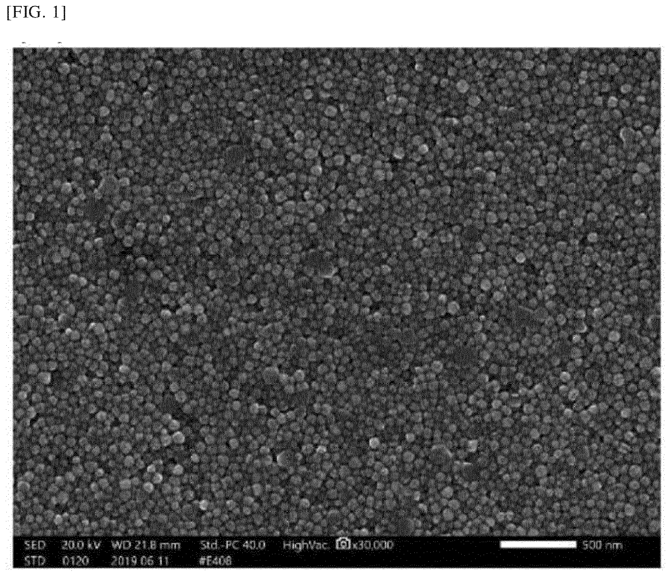

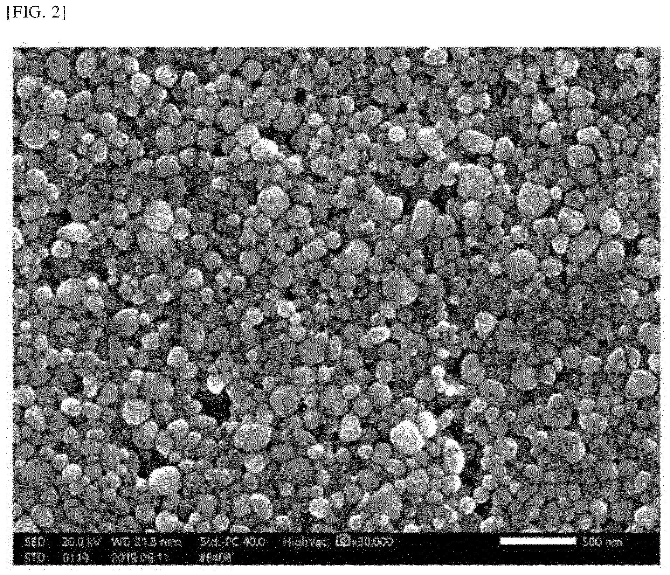

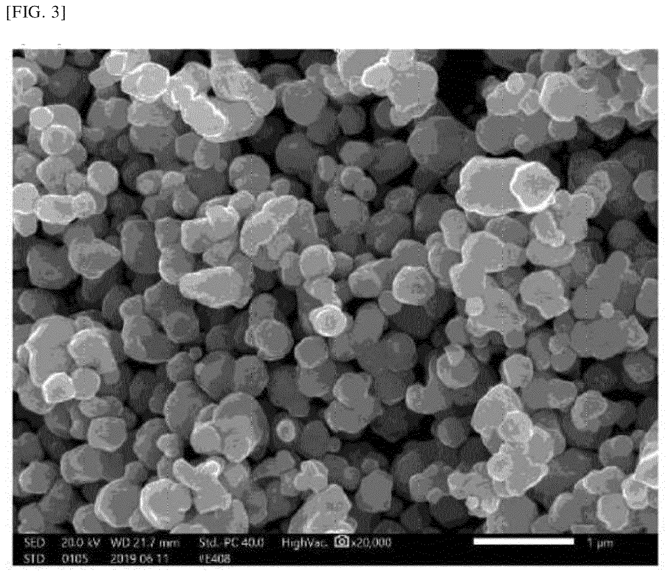

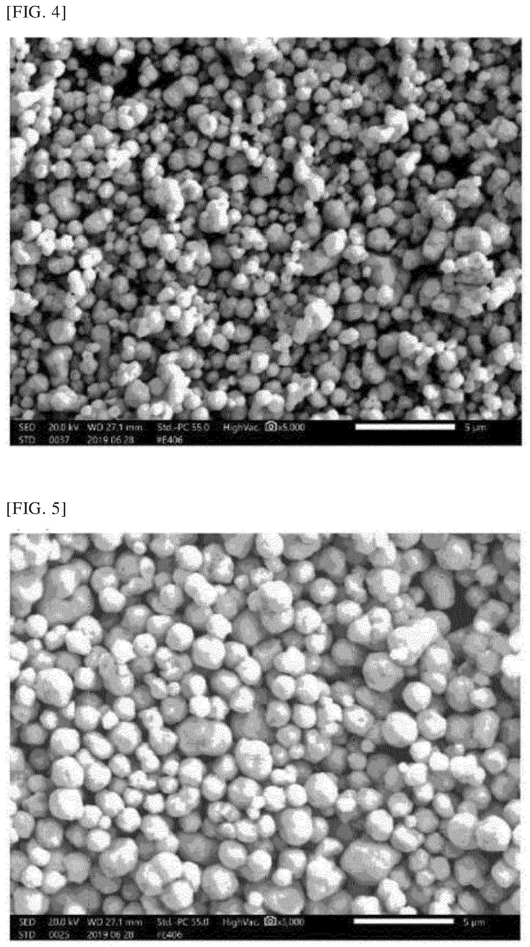

For each type of the silver particles A1, A2, B1, B2, and B3, a SEM image was acquired using a scanning electron microscope (SEM (JSM-IT500HR from JEOL Ltd.)). FIG. 1 shows a SEM image of the silver particles A1, FIG. 2 shows a SEM image of the silver particles A2, FIG. 3 shows a SEM image of the silver particles B1, FIG. 4 shows a SEM image of the silver particles B2, and FIG. 5 shows a SEM image of the silver particles B3.

<Measurement of Average Particle Diameter (Volume-Based Average Particle Diameter) and Particle Size Distribution (D10 to D100)>

In each of the SEM images (horizontal width: 1 to 20 μm) acquired in <Observation with Electron Microscope> above, the volume-based average particle diameter and the particle size distribution were measured for 200 randomly selected particles, using image analysis software (Mac-View (Mountech Co., Ltd.)). With respect to the vertical direction of the SEM image, the range with a horizontal width of 1 to 20 μm was observed. With respect to the vertical direction of the SEM image, the width was set such that 200 or more (typically about 200 to 300) silver particles were included in the range with a horizontal width of 1 to 20 μm. The volume-based average particle diameter refers to the value measured based on the assumption that the particles observed in the SEM image have a spherical shape with the diameter. The results are shown in Tables 1 and 2.

[Table 1]

|  | Silver Particles A1 | Silver Particles A2 | Silver Particles B1 | Silver Particles B2 | Silver Particles B3 |
|---|---|---|---|---|---|
| Volume-Based Average Particle Diameter | 68nm | 181nm | 0.65μm | 1.88μm | 2.21μm |

[Table 2]

|  |  | Silver Particles A1 | Silver Particles A2 | Silver Particles B1 | Silver Particles B2 | Silver Particles B3 |
|---|---|---|---|---|---|---|
| Particle Size Distribution (μm) (% by volume) | D10 | 0.055 | 0.12 | 0.41 | 0.90 | 1.38 |
|  | D20 | 0.058 | 0.13 | 0.46 | 1.05 | 1.61 |
|  | D30 | 0.061 | 0.15 | 0.50 | 1.15 | 1.80 |
|  | D40 | 0.065 | 0.16 | 0.54 | 1.26 | 1.94 |
|  | D50 | 0.068 | 0.17 | 0.58 | 1.43 | 2.09 |
|  | D60 | 0.071 | 0.19 | 0.61 | 1.65 | 2.30 |
|  | D70 | 0.074 | 0.21 | 0.69 | 1.94 | 2.54 |
|  | D80 | 0.077 | 0.23 | 0.79 | 3.27 | 2.80 |
|  | D90 | 0.084 | 0.26 | 0.99 | 3.73 | 3.20 |
|  | D100 | 0.092 | 0.31 | 1.47 | 4.14 | 4.10 |

<Thennogravimetry-Differential Thermal Analysis (TG-DTA Measurement)>

TG-DTA measurement was performed for each type of the silver particles A1 and A2. Specifically, as in <Production of Conductive Adhesives> described below, the silver particles A1 and A2 were each mixed with a solvent (Texanol) to prepare each silver particle dispersion with a concentration of 90% by mass. Next, 1 g of each silver particle dispersion was dispersed well in 2 g of added methanol, and then the silver particles were collected by filtration and air-dried to obtain a silver-particle dry powder. The obtained silver-particle dry powder was subjected to TG-DTA measurement, using HITACHI G300 AST-2. The measurement conditions were as follows: atmosphere: air, measurement temperature: 30 to 500°C, heating rate: 10°C/min. From the obtained TG-DTA chart, the weight loss on heating from 30 to 500°C by the thermal analysis was obtained. The results are shown in Table 3.

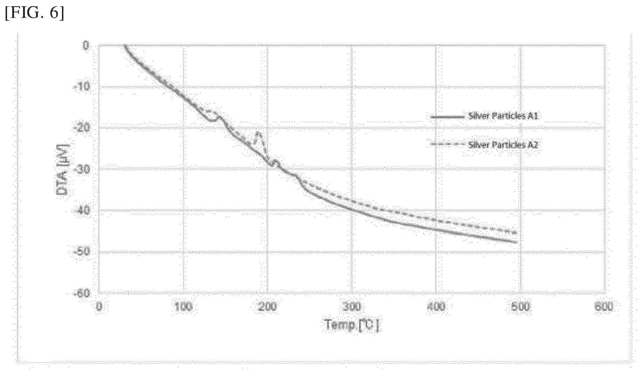

Separately, the silver particles A1 and A2 were each mixed with a solvent (Texanol) to prepare each silver particle dispersion with a concentration of 90% by mass. Each silver particle dispersion was used to measure major exothermic peaks in TG-DTA analysis, using HITACHI G300 AST-2. The measurement conditions were as follows: atmosphere: air, measurement temperature: 30 to 500°C, heating rate: 10°C/min. FIG. 6 shows the obtained TG-DTA charts. Table 3 shows the temperatures at the exothermic peaks for each type of the silver particles shown in FIG. 6.

[Table 3]

| | | Silver Particles A1 (68 nm) | Silver Particles A2 (181 nm) |
|---|---|---|---|
| DTA Exothermic Peaks (°C) | | 143 | 132 |
| | | 209 | 189 |
| | | 230 | - |
| TG Weight Loss (% by mass) | Silver Particle Dispersion | 10 | 10 |
| | Dry Powder | 1.1 | 0.6 |

<Production of Conductive Adhesives>

The silver particles A, the silver particles B, and a solvent (Texanol) were mixed to provide the compositions shown in Table 4, to prepare conductive adhesives. Specifically, Texanol was added in an amount equivalent to 10% by mass to each type of the silver particles A1, silver particles A2, silver particles B1, silver particles B2, and silver particles B3, to prepare each silver particle dispersion with a concentration of 90% by mass (silver particle dispersion A1, silver particle dispersion A2, silver particle dispersion B1, silver particle dispersion B2, or silver particle dispersion B3). The mixing was performed twice using MAZERUSTAR from Kurabo Industries Ltd. in the stirring priority mode. Next, each silver particle dispersion and Texanol were mixed to provide the composition shown in Table 4, to give a conductive adhesive with each of the compositions of Examples 1 and 2, and Comparative Example 1 to 4.

[Table 4]

| Composition of Conductive Adhesive | | Ex. 1 | Ex. 2 | Comp. Ex. 1 | Comp. Ex. 2 | Comp. Ex. 3 | Comp. Ex. 4 |
|---|---|---|---|---|---|---|---|
| Silver Particles A | Silver Particles A (68 nm) | 45 | - | - | 45 | 45 | - |
| | Silver Particles B (181 nm) | - | 45 | 45 | - | - | 45 |
| Silver Particles B | Silver Particles B 1 (0.65 μm) | 45 | - | 45 | - | - | - |
| | Silver Particles B2 (1.88 μm) | - | 45 | - | 45 | - | - |
| | Silver Particles B3 (2.21 μm) | - | - | - | - | 45 | 45 |
| Ratio of Average Particle Diameters (Silver Particles B/Silver Particles A) | | 9.56 | 10.39 | 3.59 | 27.65 | 32.50 | 12.21 |
| Solvent | | 10 | 10 | 10 | 10 | 10 | 10 |

The values recited for the silver particles A, silver particles B, and solvent in Table 4 are in part(s) by mass. In the conductive adhesives of Examples 1 and 2, and Comparative Examples 1 to 4, the content of particles with a particle diameter of less than 50 nm was 10% or less when the number of particles was taken as 100%. The content of particles with a particle diameter of less than 50 nm was measured as follows: In each SEM image (horizontal width: 1 to 20 μm) acquired in <Observation with Electron Microscope> above, volume particle diameters of 200 randomly selected particles were measured using image analysis software (Mac-View (Mountech Co., Ltd.)), and the number proportion of the particles contained therein was calculated. With respect to the vertical direction of the SEM image, the width was set (in the range of 1 to 20 $\mu$m) such that 200 or more silver particles were included in the range with a horizontal width of 1 to 20 $\mu$m.

<Production of Sintered Bodies (Sintering Temperature: 200°C>

Initially, a substrate formed of a copper sheet coated with 0.5 $\mu$m of electroless silver plating was prepared. A conductive adhesive (silver particle dispersion containing 90% by mass of the silver particles and 10% by mass of Texanol) was uniformly applied onto the substrate (silver-plated surface) to give a coating thickness of 50 $\mu$m. On the coating, a silicon wafer (size: 2 mm $\times$ 2 mm) gold-plated on the rear surface (surface brought into contact with the conductive adhesive) was laminated to obtain a laminate. Then, the obtained laminate was heated using a (circulation-type) dryer at a predetermined sintering temperature (200 or 250°C) for 60 minutes. In this manner, nine such laminates were prepared in which each conductive adhesive between the substrate and the silicon wafer had been sintered, and the substrate and the silicon wafer had been bonded with the sintered body therebetween.

For reference, the silver particle dispersion A1, silver particle dispersion A2, silver particle dispersion B1, and silver particle dispersion B2 prepared in <Production of Conductive Adhesives> above (silver particle dispersions with a concentration of 90% by mass, each formed by adding Texanol in an amount equivalent to 10% by mass to each type of the silver particles A1, silver particles A2, silver particles B1, and silver particles B2) were used as conductive adhesives (Comparative Examples 5 to 8 as shown in Table 5), and sintered bodies were produced in the same manner.

Various physical properties of the sintered bodies obtained from the conductive adhesives of Examples 1 and 2, and Comparative Example 1 to 8 were measured under the following measurement conditions.

<Mechanical Strength (Shear Strength) of Sintered Bodies>

For each of the obtained laminates, to measure the maximum load at break, a die shear test was performed for each laminate, by applying a load on the sintered body under a condition of 0.120 mm/s, using a bond tester (SS30-WD; Seishin Trading Co., Ltd.) at room temperature. The shear strength value was obtained by dividing the maximum load thus obtained by the bonded area. The measured result was the average value of the nine gold-plated silicon wafers measured for shear strength. The measured results of shear strength are shown in Table 5.

<Denseness of Sintered Bodies>

Each sintered body in the above-described laminate was resin-embedded in an epoxy resin (from Buehler), and allowed to stand for 24 hours to cure the resin. Next, the resin-embedded sintered body was cut with the precision low-speed cutter TechCut4 (ALLIED), and subjected to cross-section milling for 3 hours, using (Hitachi High-Technologies Corporation) ion milling (IM4000PLUS). The cross-section milling was performed by irradiating with an ion beam at a discharge voltage of 1.5 kV and an acceleration voltage of 6 kV, using an argon gas flow rate of 0.07 cm$^3$/min and a swing of $\pm$30°. The cross section of the sintered body obtained by the cross-section milling was observed with the scanning electron microscope JSM-IT500HR (JEOL Ltd.) to acquire an SEM image. The SED mode (secondary electron detector) was used in the observation, and a range with a horizontal width of 60 $\mu$m was observed at an acceleration voltage of 20 kV and a magnification of 2,000 times. With respect to the vertical direction of the SEM image, the vertical width of the sintered layer of silver was set in the range of 10 $\mu$m or more and 200 $\mu$m or less. To calculate the density, the obtained SEM image was converted into a two-shade image of black and white using the binarization software "Imagej", and the density was determined using the following relational expression. The measured results of denseness are shown in Table 5.

$$\text{Denseness (\%)} = \text{sintered silver area (number of white pixels)} \div \text{total area of}$$

$$\text{the sintered body } \{\text{sintered silver area (number of white pixels)} + \text{area of pores (number}$$

$$\text{of black pixels)}\} \times 100$$

<Specific Resistance of Sintered Bodies>

A conductive adhesive (silver particle dispersion containing 90% by mass of the silver particles and 10% by mass of Texanol) was uniformly applied onto a polyimide film to give a size of 2 mm $\times$ 60 mm $\times$ 50 $\mu$m in coating thickness, and fired at a predetermined temperature (200 or 250°C) for 60 minutes to obtain a sintered body. Next, the resistance of the sintered body was measured with a resistance meter (HIOKI RM3548) under room temperature conditions, using the two-terminal method, and the specific resistance (volume resistance) was determined from the actual film thickness measured with a micrometer. The specific resistance refers to the average of the values measured at four places of the sintered body. The measured results of specific resistance are shown in Table 5.

[Table 5]

| | Conductive Adhesive | Sintered Bodies (Sintering Temperature: 200°C) | | |
|---|---|---|---|---|
| | | Shear Strength (MPa) | Denseness (%) | Specific Resistance (μΩ·cm) |
| Example 1 | Silver Particles A1 (68 nm) + Silver Particles B1 (0.65 μm) | 85 | 85 | 2.8 |
| Example 2 | Silver Particles A2 (181 nm) + Silver Particles B2 (1.88 μm) | 77 | 91 | 3.0 |
| Comparative Example 1 | Silver Particles A2 (181 nm) + Silver Particles B1 (0.65 μm) | 83 | 72 | 3.5 |
| Comparative Example 2 | Silver Particles A1 (68 nm) + Silver Particles B2 (1.88 μm) | 60 | 77 | 3.5 |
| Comparative Example 3 | Silver Particles A1 (68 nm) + Silver Particles B3 (2.21 μm) | 69 | 78 | 3.9 |
| Comparative Example 4 | Silver Particles A2 (181 nm) + Silver Particles B3 (2.21 μm) | 70 | 87 | 2.9 |
| Comparative Example 5 | Silver Particles A1 (68 nm) | 65 | 87 | -(Cracking) |
| Comparative Example 6 | Silver Particles A2 (181 nm) | 78 | 69 | 3.6 |
| Comparative Example 7 | Silver Particles B1 (0.65 μm) | 39 | 72 | 6.0 |
| Comparative Example 8 | Silver Particles B2 (1.88 μm) | 10 | 69 | 6.7 |

<Cavities of Sintered Bodies (Sintering Temperature: 200°C)>

Each SEM image binarized using "Imagej", acquired in <Observation with Electron Microscope> above, was subjected to image processing (by automatic color difference reading, the cavity regions in the binarized image were analyzed as particles) using image analysis-type particle size distribution measurement software (Mac-View (Mountech Co., Ltd.)), and the number average size and the specific surface area of the cavities of the sintered body were calculated. The results are shown in Table 6. Here, the number average size was analyzed using the image analysis software (Mac-View) based on the assumption that the cavities had a spherical shape. The specific surface area was determined by calculating the surface area per unit volume of the spherical shape.

[Table 6]

| | Conductive Adhesive | Cavities of Sintered Bodies (Sintering Temperature: 200°C) | |
|---|---|---|---|
| | | Number Average Size μm) | Specific Surface Area (μm²) |
| Example 1 | Silver Particles A1 (68 nm) + Silver Particles B1 (0.65 μm) | 0.521 | 0.192 |
| Example 2 | Silver Particles A2 (181 nm) + Silver Particles B2 (1.88 μm) | 0.716 | 0.719 |

<Production of Sintered Bodies (Sintering Temperature: 250°C>

Using each of the conductive adhesives of Examples 1 and 2, a sintered body was obtained as in <Production of Sintered Bodies (Sintering Temperature: 200°C> above, except that the sintering temperature was set to 250°C. The obtained sintered body was also measured for shear strength, denseness, and specific resistance, as in <Mechanical Strength (Shear Strength) of Sintered bodies>, <Denseness of Sintered Bodies>, and <Specific Resistance of Sintered Bodies> above. The results are shown in Table 7.

[Table 7]

| | Conductive Adhesive | Sintered Bodies (Sintering Temperature: 250°C) | | |
|---|---|---|---|---|
| | | Shear Strength (MPa) | Denseness (%) | Specific Resistance ($\mu\Omega\cdot$cm) |
| Example 1 | Silver Particles A1 (68 nm) + Silver Particles B1 (0.65 $\mu$m) | 72 | 93 | 2.9 |
| Example 2 | Silver Particles A2 (181 nm) + Silver Particles B2 (1.88 $\mu$m) | 77 | 87 | 2.5 |

<Cavities of Sintered Bodies (Sintering Temperature: 250°C)>

A SEM image of each sintered body obtained in <Production of Sintered Bodies (Sintering Temperature: 250°C> was acquired as in <Observation with Electron Microscope> above, and each SEM image was subjected to image processing (by automatic color difference reading, the cavity regions in the binarized image were analyzed as particles) using image analysis-type particle size distribution measurement software (Mac-View (Mountech Co., Ltd.)), and the number average size and the specific surface area of the cavities of the sintered body were calculated. The results are shown in Table 8. Here, the number average size was analyzed using the image analysis software (Mac-View) based on the assumption that the cavities had a spherical shape. The specific surface area was determined by calculating the surface area per unit volume of the spherical shape.

[Table 8]

| | Conductive Adhesive | Cavities of Sintered Bodies (Sintering Temperature: 250°C) | |
|---|---|---|---|
| | | Number Average Size ($\mu$m) | Specific Surface Area ($\mu$m$^2$) |
| Example 1 | Silver Particles A1 (68 nm) + Silver Particles B1 (0.65 $\mu$m) | 0.654 | 0.278 |
| Example 2 | Silver Particles A2 (181 nm) + Silver Particles B2 (1.88 $\mu$m) | 0.907 | 0.518 |

**Claims**

1. Silver particles comprising:

   silver particles A with an average particle diameter in the range of 50 to 500 nm; and
   silver particles B with an average particle diameter in the range of 0.5 to 5.5 $\mu$m,
   wherein the silver particles satisfy a relationship in which the average particle diameter of the silver particles B is 5 to 11 times the average particle diameter of the silver particles A.

2. The silver particles according to claim 1, wherein the mass ratio of the silver particles A to the silver particles B is in the range of 1:9 to 9:1.

3. The silver particles according to claim 1 or 2, wherein an amine compound is adhered to a surface of the silver particles A.

4. The silver particles according to any one of claims 1 to 3, wherein the silver particles comprise silver particles with a particle diameter of less than 50 nm.

5. A conductive adhesive comprising the silver particles according to any one of claims 1 to 4 and a solvent.

6. A sintered body of the conductive adhesive according to claim 5.

7. An electronic part in which members are bonded with the sintered body according to claim 6.

8. A method for producing a sintered body, comprising the step of sintering the conductive adhesive according to claim 5 at a temperature of 200°C or more and 250°C or less.

9. A method for producing an electronic part in which members are bonded with a sintered body, comprising the steps of:

    placing the conductive adhesive according to claim 5 between the members; and
    sintering the conductive adhesive at a temperature of 200°C or more and 250°C or less.

EP 4 026 630 A1

[FIG. 1]

18

[FIG. 2]

[FIG. 3]

[FIG. 4]

[FIG. 5]

[FIG. 6]

## INTERNATIONAL SEARCH REPORT

| | International application No. |
|---|---|
| | PCT/JP2020/030725 |

### A. CLASSIFICATION OF SUBJECT MATTER

B22F 1/00(2006.01)i; B22F 1/02(2006.01)i; B22F 7/08(2006.01)i; H01B
1/00(2006.01)i; H01B 1/22(2006.01)i; H01B 5/00(2006.01)i; H01L
21/52(2006.01)i
FI:     B22F1/00 K; B22F1/02 D; B22F1/02 B; B22F7/08 C; H01B5/00 K;
        H01B5/00 E; H01B1/00 E; H01B1/00 K; H01B1/22 D; H01L21/52 E

According to International Patent Classification (IPC) or to both national classification and IPC

### B. FIELDS SEARCHED

Minimum documentation searched (classification system followed by classification symbols)
B22F1/00; B22F1/02; B22F7/08; H01B1/00; H01B1/22; H01B5/00; H01L21/52

Documentation searched other than minimum documentation to the extent that such documents are included in the fields searched
Published examined utility model applications of Japan      1922–1996
Published unexamined utility model applications of Japan    1971–2020
Registered utility model specifications of Japan            1996–2020
Published registered utility model applications of Japan    1994–2020

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2007-018884 A (NORITAKE CO., LTD.) 25 January 2007 (2007-01-25) claims, paragraph [0033], table 1 | 1-2 |
| Y | claims, paragraph [0033], table 1 | 3-9 |
| X | WO 2015/163076 A1 (DAICEL CORPORATION) 29 October 2015 (2015-10-29) claims, paragraphs [0015], [0120] | 1-4 |
| Y | claims, paragraphs [0015], [0120] | 3-9 |
| X | WO 2015/194536 A1 (OSAKA UNIVERSITY) 23 December 2015 (2015-12-23) claims, paragraphs [0001], [0051], [0069], fig. 4 | 1, 2, 4-7 |
| Y | claims, paragraphs [0001], [0051], [0069], fig. 4 | 3, 5-9 |

☐ Further documents are listed in the continuation of Box C.      ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 15 October 2020 (15.10.2020) | 27 October 2020 (27.10.2020) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

23

**INTERNATIONAL SEARCH REPORT**

Information on patent family members

| International application No. |
|---|
| PCT/JP2020/030725 |

| Patent Documents referred in the Report | Publication Date | Patent Family | Publication Date |
|---|---|---|---|
| JP 2007-018884 A | 25 Jan. 2007 | (Family: none) | |
| WO 2015/163076 A1 | 29 Oct. 2015 | US 2017/0043396 A1 claims, paragraphs [0036], [0164] EP 3135405 A1 claims, paragraphs [0015], [0099] CN 106232268 A KR 10-2016-0149220 A TW 201542713 A | |
| WO 2015/194536 A1 | 23 Dec. 2015 | US 2017/0144220 A1 claims, paragraphs [0001], [0072], [0091], fig. 4 EP 3156157 A1 claims, paragraphs [0001], [0051], [0070], fig. 4 CN 106660131 A TW 201602365 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 201018712 A
- JP 2015159096 A
- JP 5574761 B